Europäisches Patentamt

European Patent Office

Office européen des brevets

(11) Veröffentlichungsnummer: **0 597 404 A2**

(12) **EUROPÄISCHE PATENTANMELDUNG**

(21) Anmeldenummer: **93118013.7**

(51) Int. Cl.5: **G01R 15/02**

(22) Anmeldetag: **06.11.93**

(30) Priorität: **13.11.92 DE 4238356**

(43) Veröffentlichungstag der Anmeldung:
**18.05.94 Patentblatt 94/20**

(84) Benannte Vertragsstaaten:
**DE FR GB IT SE**

(71) Anmelder: **ABB PATENT GmbH**
**Kallstadter Strasse 1**
**D-68309 Mannheim(DE)**

(72) Erfinder: **Wiesener, Torsten**
**Hainstrasse 12**
**D-12439 Berlin(DE)**

(74) Vertreter: **Rupprecht, Klaus, Dipl.-Ing. et al**
**c/o ABB Patent GmbH,**
**Postfach 10 03 51**
**D-68128 Mannheim (DE)**

(54) **Verfahren und Einrichtung zur Ermittlung der Leiterströme eines Mehrleitersystems.**

(57) Das erfindungsgemäße Verfahren zur Ermittlung von Leiterströmen basiert auf einer meßtechnischen Erfassung vektorieller magnetischer Feldstärken im Summenmagnetfeld eines Mehrleitersystems. Die einzelnen Leiterströme werden auf der Grundlage der gemessenen Feldstärken berechnet. Eine geeignete Meßanordnung zur Durchführung des Verfahrens umfaßt eine der Leiterzahl äquivalente Anzahl von Sensoren (S1 bis S3) oder im Fall eines Drehstromsystems auch nur zwei Sensoren, die im Summen-Magnetfeld nahe am Dreileitersystem (1) und innerhalb einer magnetischen Abschirmeinrichtung (4) angeordnet sind und mit einer Auswerteeinrichtung (5) verbunden sind.

Fig. 1

EP 0 597 404 A2

Die Erfindung bezieht sich auf ein Verfahren und eine Einrichtung zur Ermittlung der elektrischen Ströme in den einzelnen Leitern eines Mehrleitersystems.

Mehrleitersysteme sind z. B. Drehstromkabel oder Mehrleiteranordnungen in Anlagen, z. B. Schaltanlagen, zur elektrischen Energieversorgung.

Insbesondere in elektrischen Energieversorgungssystemen werden nach dem Stand der Technik zur Strommessung fast ausschließlich induktive Stromwandler eingesetzt. Sie erfüllen die technischen Anforderungen an die Genauigkeit, Betriebssicherheit und Wartungsarmut. Allerdings sind sie relativ aufwendig hinsichtlich Materialeinsatz, Herstellkosten, Gewicht und Platzbedarf und erfordern in Mehrleitersystemen die Zugänglichkeit der einzelnen Leiter. Um nur das Magnetfeld eines Einzelleiters zu erfassen, wird dieser mit einem Eisenkern umfaßt.

Seit längerem werden deshalb Möglichkeiten zur Strommessung mit neuen unkonventionellen Wandlern untersucht. Dazu zählen auch Verfahren und Einrichtungen, die mit Sensoren arbeiten, die den Hall-Effekt benutzen oder die auf magnetoresistiven Halbleitersensoren basieren. Sensoren, die den magnetoresistiven Effekt nutzen, sind seit Jahren marktgängig und z. B. in der Technischen Information 861105 "Anwendungen der Magnetfeldsensoren KMZ 10" der Firma VALVO beschrieben. Dort wird auch eine Anordnung zur Strommessung als Applikationshinweis beschrieben, in der ein Magnetfeldsensor im Luftspalt eines Magnetkerns angeordnet ist, der einen elektrischen Leiter umgibt. Eine solche Anordnung, die einen magnetischen Vorzugsweg enthält, ist allerdings ungeeignet zur Strommessung oder Betriebszustandserfassung in einem Mehrleitersystem, dessen Einzelleiter nicht für eine Messung zugänglich sind. Mit einer Betriebszustandserfassung soll festgestellt werden, ob ein Strom im Mehrleitersystem fließt.

Eine Einrichtung zur Messung der Leiterströme in einem Mehrleitersystem, bei der die Leiter nicht einzeln für eine Messung zugänglich sein müssen, ist aus der DE 28 45 155 C2 bekannt. Die Messung erfolgt dort mit Hilfe von Feldspulen, die in einem festen Abstand von etwa 30 cm von den Leitern hinter einer Isolierstoffplatte angeordnet sind. Der Abstand zwischen den elektrischen Leitern muß groß sein, damit die bei diesem Verfahren unerwünschten magnetischen Einflüsse durch die Nachbarleiter klein sind und mit Hilfe von Potentiometern im Meßsignalweg eliminiert werden können. Als einzige Anwendung der Meßeinrichtung sind mehrphasige Mittelspannungsanlagen genannt, was aufgrund der verfahrensbedingten Beschränkungen zutreffend ist.

Der Erfindung liegt davon ausgehend die Aufgabe zugrunde, ein Verfahren und eine Einrichtung für Mehrleitersysteme anzugeben, das bzw. die eine Ermittlung der Einzelleiterströme oder eine Betriebszustandserfassung auch dann erlaubt, wenn die einzelnen Leiter nicht zur direkten Einzelstrommessung zugänglich sind und wenn der Abstand zwischen den Leitern klein ist, wie z.B. bei einem Niederspannungskabel.

Diese Aufgabe wird gelöst durch ein Verfahren zur Ermittlung der einzelnen Leiterströme eines Mehrleitersystems, wobei

a) das Mehrleitersystem eine Anzahl n>1 elektrischer Leiter und Mittel zur elektrischen Isolierung enthält, und

b) mit meßtechnischen Mitteln magnetische Feldstärken vektoriell erfaßt werden, die die Summenfeldstärken der Magnetfelder aller Einzelleiter sind,

c) die Anzahl m der Meßorte wenigstens n-1 beträgt,

d) an den Meßorten jeweils ein Sensor unmittelbar am Mehrleitersystem angeordnet wird, wobei die Sensoren durch unterschiedliche geometrische Winkel ausreichend räumlich voneinander getrennt angeordnet werden, um deutlich unterschiedliche Wirkungen der strombegleitenden Magnetfelder der einzelnen Leiter auf die Sensoren zu erzielen, und

e) die Einzelströme der Leiter auf den Grundlagen der gemessenen Feldstärken durch numerische Berechnung ermittelt werden, wobei Berechnungsformeln benutzt werden, die neben den Winkeln der Phasenverschiebung auch die geometrischen Winkel der vektoriell empfindlichen Achsen der Sensoren zueinander und die physikalischen Abhängigkeiten der vektoriellen magnetischen Feldstärken vom Meßort und von den einzelnen Leiterströmen berücksichtigen.

Das Wesen der Erfindung besteht darin, nicht das einzelne Magnetfeld des elektrischen Leiters, sondern das Summen-Magnetfeld, das in einem Mehrleitersystem durch Überlagerung der einzelnen Magnetfelder entsteht, zu Meßzwecken heranzuziehen. Es werden an mehreren Orten im Summen-Magnetfeld vektorielle magnetische Feldstärken erfaßt. Während bei bekannten Verfahren der Einfluß durch Überlagerung von Magnetfeldern, d.h. der Einfluß durch Nachbarleiter möglichst klein gehalten wird, ist beim erfindungsgemäßen Verfahren diese Überlagerung gewünscht und wird durch eine kompakte Anordnung von Leitern und die Anordnung von Sensoren direkt am Mehrleitersystem, also an den elektrisch isolierten Leitern, gefördert. Auf der Grundlage so gewonnener Meßsignale lassen sich auch unterschiedlich hohe Ströme in den einzelnen Leitern berechnen.

Das erfindungsgemäße Verfahren hat eine Reihe von Vorteilen. Es ermöglicht sogar mit weniger Sensoren als Ströme zu ermitteln sind zu arbeiten, also z. B. mit zwei Sensoren zur Erfassung der Ströme eines Dreileitersystems. Da das Summen-Magnetfeld benutzt wird, ist keine Aufteilung des Mehrleitersystems, z. B. eines Mehrleiterkabels in Einzelleiter erforderlich. Es wird kein magnetischer Vorzugsweg geschaffen, wodurch kein Magnetkernmaterial zur Umfassung von Leitern benötigt wird.

Die genannte Aufgabe wird außerdem gelöst durch eine Einrichtung zur Ermittlung der einzelnen Leiterströme eines Mehrleitersystems mit Hilfe von Sensoren, die an mehreren Orten um das Mehrleitersystem herum angeordnet sind, wobei das Mehrleitersystem eine Anzahl n>1 elektrischer Leiter und Mittel zur elektrischen Isolierung aufweist, und wobei

a) die Anzahl m der Meßorte wenigstens n-1 beträgt,

b) die Sensoren unmittelbar am Mehrleitersystem innerhalb dessen Summen-Magnetfelds angeordnet sind, und jeweils ein einer vektoriellen magnetischen Feldstärke proportionales elektrisches Meßsignal liefern,

c) das Mehrleitersystem einschließlich Sensoren von einer magnetischen Abschirmeinrichtung umgeben ist, die Fremdeinflüsse auf die Meßanordnung weitgehend ausschließt, und die elektrischen Meßsignale mit Hilfe von Verbindungsleitungen von den Sensoren zu einer Meßwertverarbeitungseinrichtung geführt sind, in der auf der Grundlage der Meßwerte Leiterströme berechnet und an einem Ausgang zur Verfügung gestellt sind.

Die Einrichtung läßt sich mit vorteilhaft geringem Material- und Herstellungsaufwand realisieren. Sie hat ein vergleichbar geringes Gewicht und geringen Platzbedarf.

Eine ausführliche Beschreibung der Erfindung erfolgt nachstehend anhand von in den Zeichnungen dargestellten Ausführungsbeispielen. Dabei werden auch physikalische Grundlagen und vorteilhafte Ausgestaltungen erläutert.

Es zeigen:

Figur 1      eine geometrische Anordnungsart zur Messung von drei Leiterströmen eines Drehstromes mit drei magnetoresistiven Sensoren,

Figur 2 und 3      Magnetfeldvektoren im Fall einer Anordnung nach Figur 1,

Figur 4      eine zur Erläuterung des Meßprinzips vereinfachte Anordnungsart zur Messung von drei Leiterströmen eines Drehstromnetzes mit nur zwei magnetoresistiven Sensoren,

Figur 5      Magnetfeldvektoren im Anordnungsbeispiel nach Figur 4,

Figur 6      Darstellung von Magnetfeldzeigern in der komplexen Zahlenebene,

Figur 7      elektrische Meßsignale am Ausgang der Sensoren,

Figur 8 bis 11      Darstellung von geometrischen Anordnungen und zugehörigen Magnetfeldzeigern, die zur Erläuterung der Leiterstromberechnung herangezogen werden.

Das erfindungsgemäße Verfahren gliedert sich in zwei Hauptschritte, nämlich in eine Erfassung vektorieller Feldstärken mit Umsetzung in elektrische Signale und in eine Ermittlung der Leiterströme durch Auswertung der elektrischen Signale. Die nachstehenden Ausführungen beziehen sich zunächst hauptsächlich auf die Erfassung der vektoriellen Feldstärken. Eine Beschreibung des zweiten Verfahrensschrittes erfolgt weiter unten.

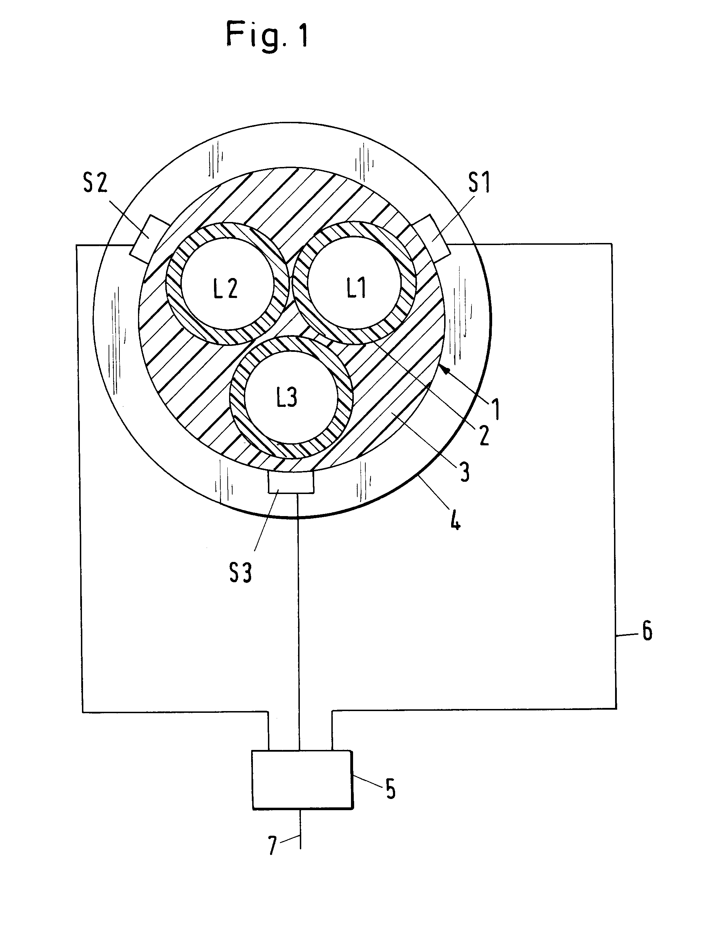

Figur 1 zeigt eine erfindungsgemäße Anordnung zur Messung der drei Leiterströme eines Drehstromkabelsystems 1 unter Verwendung einer der Leiterzahl entsprechenden Anzahl von magnetischen Sensoren S1 bis S3. Die elektrischen Leiter des Systems sind mit L1 bis L3 bezeichnet. Die elektrischen Leiter L1 bis L3 sind jeweils mit einer Leiterisolierung 2 umgeben. Mit Bezugszeichen 3 ist eine Zusatz-, Zwischen- und Kabelisolierung bezeichnet. Das Kabel 1 einschließlich Sensoren S1 bis S3 ist mit einer magnetischen Abschirmeinrichtung 4 umgeben. Die Sensoren S1 bis S3 sind mit einer Meßwertverarbeitungseinrichtung 5 über Leitungen 6 verbunden, die außer einer Signalaufbereitung eine Berechnung der Leiterströme unter Verwendung der Meßwerte durchführt und die Ergebnisse zur weiteren Verwertung, z. B. für eine Anzeige oder zur Weiterleitung an leittechnische Einrichtungen an einer Ausgabe 7 zur Verfügung stellt. Es versteht sich, daß sich innerhalb der Abschirmeinrichtung 4 keine abschirmenden Materialien oder magnetischen Vorzugswege befinden dürfen, die eine freie Magnetfeldausbreitung behindern würden.

In einer Anordnung gemäß Figur 1 wirken alle drei Leiterströme über ihre strombegleitenden Magnetfelder auf alle Sensoren S1 bis S3 ein. Die Stärke der Wirkung ist jeweils abhängig vom Abstand des Leitermittelpunktes zum Sensor, und vom Winkel der Leiteranordnung zum Sensor. Da diese geometrischen Gegebenheiten für einen jeden Leiter bezüglich aller drei Sensoren bei dichter Heranbringung des Sensors an die Leiteranordnung und genügender räumlicher Trennung der Sensoren unterschiedlich ist, ist die Wirkung des strombegleiteten Magnetfeldes eines jeden Leiterstroms auf jeden Sensor unterschiedlich.

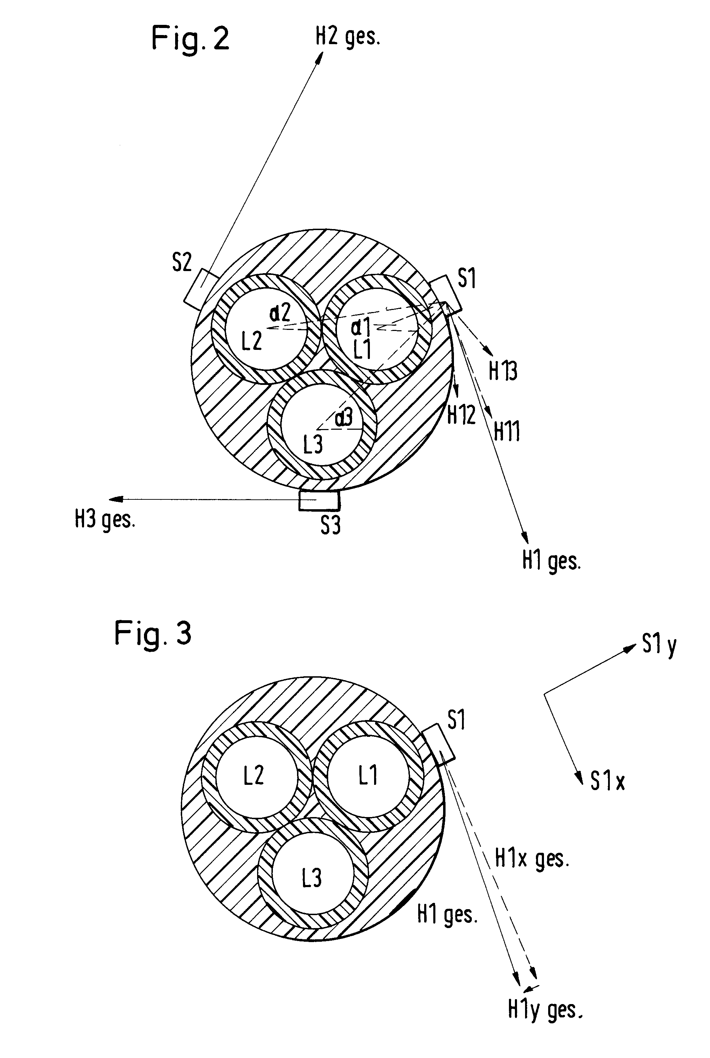

Im Anordnungspunkt des magnetoresistiven Sensors, ebenso wie im jeden anderen Punkt des Raumes, überlagern sich die einzelnen Magnetfelder der Leiterströme zu einem Summen-Magnetfeld. Diese Überlagerung sowie auch die für die vektoriellen Betrachtungen wichtigen Winkel der Leiter-Sensor-Anordnung sind in Figur 2 dargestellt. Bei den weiteren Betrachtungen ist zu beachten, daß das magnetoresistive Sensormaterial nur für magnetische Felder entlang einer geometrischen Achse, die im weiteren mit dem Index x bezeichnet wird, empfindlich ist. Somit macht sich eine Zerlegung der Summen-Magnetfelder $H1_{ges}$, $H2_{ges}$, $H3_{ges}$ am jeweiligen Sensorort in eine wirksame x-Komponente, z. B. $H1_{xges}$ und eine für den Sensor unwirksame y-Komponente, z. B. $H1_{yges}$ notwendig. Diese Aufteilung ist in Figur 3 für einen Sensorort dargestellt.

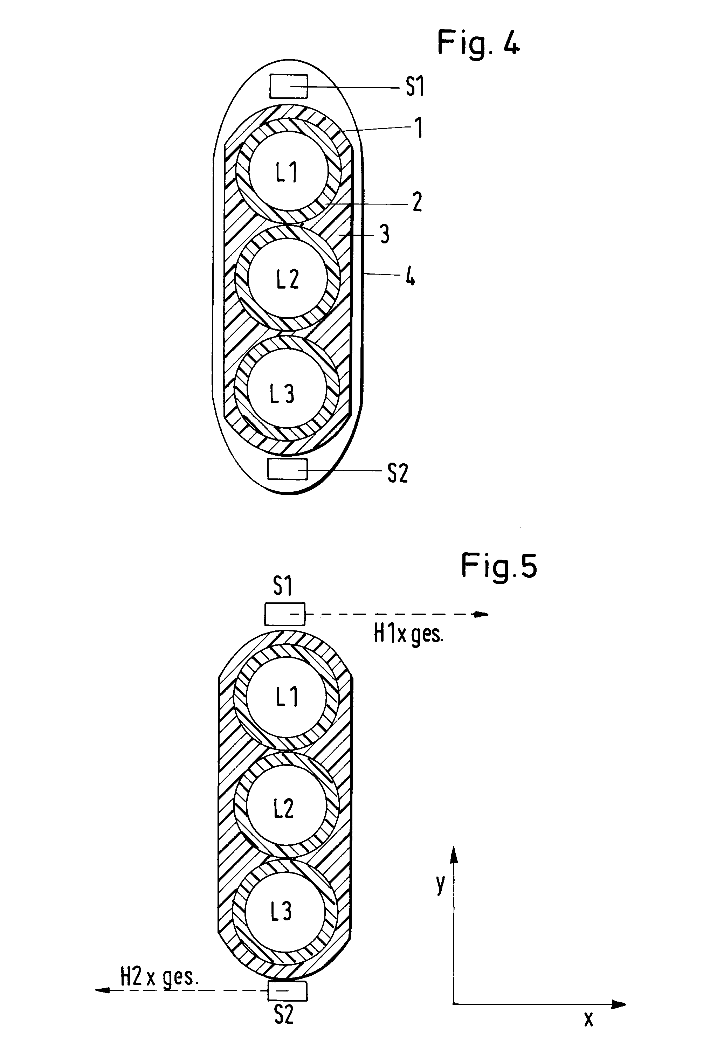

Neben der vektoriellen Betrachtung der Addition von magnetischen Feldern im Raum und ihrer Aufteilung in wirksame und unwirksame Komponenten, ist bezüglich der Messung periodisch schankender Größen noch eine zeitliche Betrachtung notwendig. Diese wird der Einfachheit halber an einer in Figur 4 gezeigten Anordnung vorgenommen, ist jedoch allgemeingültig. Die Bedeutung der Bezugszeichen stimmt in allen Figuren der Zeichnung überein. In der Anordnung gemäß Figur 4 sind drei Leiter L1 bis L3 übereinander angeordnet mit je einem Sensor S1, S2 oben und unten.

Für die Anordnung gemäß Figur 4 ergeben sich nach der räumlichen Betrachtungsweise zwei wirksame Magnetfeldkomponenten $H1_{xges}$ und $H2_{xges}$, wie in Figur 5 dargestellt. Im Fall eines sinusförmigen Charakters der drei Leiterströme sind die Magnetfeldvektoren ebenfalls periodisch schwankende Größen. Deshalb ist eine Betrachtung in der komplexen Gaußschen Zahlenebene erforderlich.

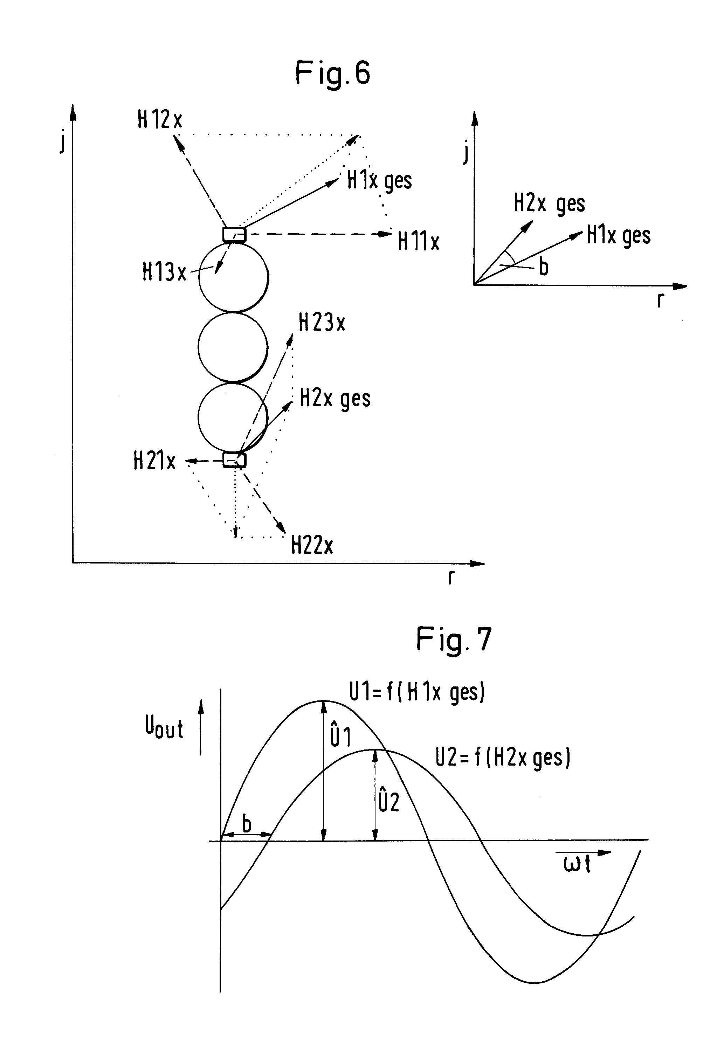

Die sich aufgrund des Drehstromcharakters der Leiterströme ergebende Zusammensetzung der Zeiger in der komplexen Zahlenebene ist in Figur 6 dargestellt. Die entstehenden Ergebnisgrößen $H1_{xges}$ und $H2_{xges}$ sind nochmals in einem diesen Betrachtungspunkt zugrundegelegten komplexen Koordinatensystem (r, j) eingezeichnet. Wie erkennbar ist, addiert sich vektoriell zu einem Magnetfeldzeiger H11x ein Magnetfeldzeiger H12x der gegenüber H11x eine Phasenverschiebung von 120° aufweist, und ein Magnetfeldzeiger H13x, der gegenüber H11x eine Phasenverschiebung von 240° besitzt. H11x stellt dabei die wirksame Komponente (H11$\underline{x}$) des Magnetfeldvektors H11, hervorgerufen durch den Leiterstrom 1 (H1$\underline{1}$x) im Punkt des Magnetfeldsensors 1 (H$\underline{1}$1x) dar. Im Bezug auf die anderen Zeiger gelten die Indices analog.

Diese Ergebnisgrößen, die magnetischer Natur sind, werden durch die magnetoresistiven Sensoren in elektrische Größen umgewandelt und man erhält die Größen $U1_{max}$, $U2_{max}$ als Amplitudenwerte, sowie den Winkel b. Ein diese Größen wiedergebendes Kurvenbild, wie es ein Oszilloskop liefert, ist in Figur 7 dargestellt.

Die Betrachtung der mit den zugrundegelegten Sensoren erfaßten vektoriellen Feldstärken anhand der Figuren 4 bis 7 macht deutlich, daß grundsätzlich mit zwei Sensoren die Einzelströme eines Drehstromsystems ermittelt werden können. Vorausgesetzt ist allerdings, daß zwischen den Leiterströmen eine Symmetrie erster Ordnung vorhanden ist und somit der elektrische Winkel zwischen den Strömen bekannt ist. Wenn diese Voraussetzung gegeben ist, kann auch im Fall einer Leiteranordnung wie in Figur 1 gezeigt, mit nur zwei Sensoren gearbeitet werden.

Die Erfindung kann grundsätzlich mit Sensoren unterschiedlicher Art realisiert werden, soweit sie vektorielle Feldstärken erfassen können. Besonders geeignet sind magnetoresistive Sensoren, wie sich aus nachstehenden Ausführungen ergibt.

Ein magnetoresistiver Sensor besteht aus einem speziell hergestellten ferromagnetisch dünnen Streifenleiter, z. B. aus Permalloy.

Ferromagnetika sind innerhalb makroskopischer Bereiche spontan bis zur Sättigung magnetisiert. Während in ferromagnetischen Körpern größerer Ausdehnung die Magnetisierungsrichtungen der Bereiche spontaner Magnetisierung wahllos verteilt sind, bildet sich in dünnen Streifenleitern schon aufgrund ihrer Geometrie eine Vorzugsachse der Magnetisierung aus. Durch spezielle Maßnahmen beim Bedampfen des Substrates werden Streifenleiter geschaffen, die eine magnetische Einbereichsstruktur bilden, also aus einer einzigen magnetischen Domäne bestehen. Der Vektor der spontanen Magnetisierung ist in diesen Streifenleitern entlang der Längsachse oder Vorzugsachse orientiert. Wirkt innerhalb der Schichtebene des ferromagnetisch dünnen Streifenleiters im rechten Winkel zur Längsachse eine Magnetfeldkomponente, so lenkt diese den Vektor der spontanen Magnetisierung aus. Der Winkel der Auslenkung stellt eine direkte Aussage über die wirkende Magnetfeldkomponente, also Feldstärkekomponente dar. Die Auslenkung des Vektors der spontanen Magnetisierung erfolgt trägheitslos und nahezu hysteresefrei. Unter Ausnutzung des anisotropen Magnetowiderstandseffektes läßt sich diese Auslenkung durch ein elektrisches Signal abbilden. Dieser in ferromagnetischen Materialien auftretende Effekt besteht in der Abhängigkeit des spezifischen elektrischen Widerstandes vom Winkel zwischen der spontanen Magnetisierung und einem angelegten elektrischen Strom I, der zu messen ist. Zwingt man den elektrischen Strom den Streifenleiter im Winkel von 45° gegenüber der Vorzugsachse zu durchströmen, so ergibt sich ein Kennlinienverlauf, der in einem nullwertnahen Bereich der Signalfeldstärke einen vorteilhaft linearen Bereich aufweist.

Der lineare Bereich der Kennlinie vereinfacht eine technische Nutzung für Meßzwecke. Eine technische Variante einen Meßstrom in die 45°-Richtung gegenüber der Vorzugsachse zu zwingen, ist das Aufdampfen von hochleitfähigen Streifen, sogenannter Barber-Pole, im Winkel von 45° zur Vorzugsachse. Neben dieser Methode zur Linearisierung magnetoresistiver Elemente existieren weitere Möglichkeiten, z. B. die Anwendung vormagnetisierter Felder, der Einsatz magnetostatisch gekoppelter Schichten, sowie schräg gelegter Anisotropieachsen. Die Wahl dieser Varianten hängt dann von den speziellen Einsatzbedingungen der Meßstreifen ab. Die Herstellung des Sensors ist unter Nutzung der Dünnschichttechnologie einfach möglich.

Aufgrund stets vorhandener Inhomogenitäten der Magnetisierung der Meßstreifen ergeben sich vollständig hysteresefreie Kennlinien jedoch nur, wenn durch ein schwaches Zusatzfeld parallel zur Vorzugsachse eine Ausrichtung der Magnetisierung erfolgt. Diese ist z. B. über einen Permanentmagneten, magnetische Hilfsschichten oder im einfachsten Fall durch das Magnetfeld des Meßstromes leicht zu erzeugen. Derartige Zusatzfelder bewirken eine Ausdehnung des Linearitätsbereiches und damit verbundener Absenkung der Empfindlichkeit, wobei die magnetische Stabilität jedoch wesentlich erhöht wird. Da der magnetoresistive Sensor einen relativ hohen Temperaturkoeffizienten hat, ist die Anordnung in einer Brückenschaltung üblich.

Die von den Sensoren gelieferten elektrischen Signale repräsentieren - wie dargelegt - vektorielle magnetische Feldstärken. Zur Ermittlung der Leiterströme muß auf der Grundlage der Meßergebnisse eine Berechnung durchgeführt werden. Dazu werden die Meßsignale, wie in Figur 1 dargestellt, von den Sensoren S1 bis S3 über Verbindungsleitungen 6 einer Meßwertverarbeitungseinrichtung 5 zugeführt. Die Meßwertverarbeitungseinrichtung 5 enthält die notwendige Hardware und Software zur Berechnung der Leiterströme. Auch eventuell erforderliche Signalvorverarbeitungen, wie Signalverstärkung oder Linearisierung, soweit sie nicht in den Sensoren erfolgt, können in der Meßwertverarbeitungseinrichtung vorgenommen werden, sowie auch eine Speicherung exemplarischer Koeffizienten von Sensoren bzw. deren Funktionen. Außerdem können eventuell erforderliche Umformungen der auszugebenden Leiterströme zur Anpassung an eine geforderte Darstellungsform an der Ausgabe 7, die eine Anzeige, Übertragung oder Weiterverarbeitung in leittechnischen Einrichtungen erleichtern, vorgenommen werden.

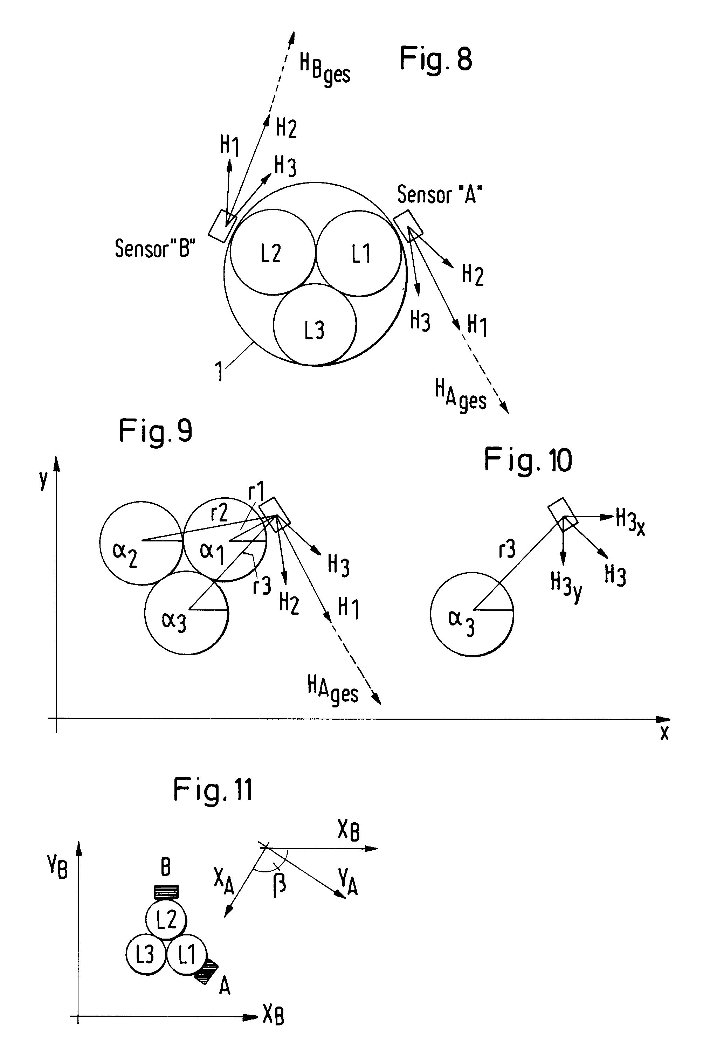

In der Verarbeitungseinrichtung 5 werden Rechenprogramme verwendet, die auf nachstehend erläuterten theoretischen Grundlagen beruhen. Die Ausführungen beziehen sich auf einen geometrischen Meßaufbau, der in Figur 8 gezeigt ist. Die Anordnung unterscheidet sich von der in Figur 1 gezeigten Anordnung lediglich dadurch, daß nur zwei Sensoren A und B an einem Mehrleitersystem 1 mit drei Leitern L1, L2, L3 angeordnet sind.

Das Durchflutungsgesetz für ein magnetisches Feld H außerhalb eines stromdurchflossenen Leiters ergibt:

$$\oint \vec{H} \, \vec{dl} = I \tag{1}$$

l = Integrationsweg
I = elektrischer Strom

Aus Gründen der Symmetrie ist die magnetische Feldstärke H in allen Punkten mit dem gleichen Abstand zum Leitermittelpunkt gleich groß und es gilt somit:

$$\oint H\vec{e}_\nu \, \vec{dl}\vec{e}_\nu = 2\pi r H = I \qquad\qquad H = \frac{I}{2\pi r} \tag{2}$$

$$\vec{H} = \frac{I}{2\pi r}\vec{e}_\nu \tag{3}$$

worin bedeuten:

$$\vec{e}_\nu = \text{Richtungsvektor}$$

r = Radius des elektrischen Leiters

Der größte Wert der magnetischen Feldstärke ist danach direkt an der Leiteroberfläche zu finden und der Betrag der magnetischen Feldstärke fällt umgekehrt proportional zum Abstand vom Leitermittelpunkt. Dabei stellt der Feldstärkeverlauf eine Hyperbel dar. Für die weiteren Berechnungen ist, aufgrund des vektoriellen Charakters der magnetischen Feldstärke, eine Aufteilung der magnetischen Feldstärke in die Einzelkomponenten gemäß des benutzten Koordinatensystems notwendig. Als erste Unterteilung erfolgt eine Unterteilung nach dem kartesischen Koordinatensystem in Komponenten der x- und der y-Richtung. Somit ergibt sich:

$$H_x = |H| \, \sin\alpha = \frac{I}{2\pi r} \, \sin\alpha \qquad\qquad (4)$$

$$H_y = -|H| \cos\alpha = -\frac{I}{2\pi r} \, \cos\alpha \qquad\qquad (5)$$

Die graphische Darstellung dieser Unterteilung ist aus Figur 10 ersichtlich. Durch die Unterteilung der Feldstärke in geometrische Komponenten ist eine Addition mehrerer magnetischer Feldstärken, hervorgerufen von unterschiedlichen elektrischen Strömen $I_i$ zu einer Summenfeldstärke möglich. Hierbei gilt:

$$H_x = \Sigma \, H_{x_i} = \frac{1}{2\pi} \, \Sigma \, \frac{I_i \, \sin\alpha_i}{r_i} \qquad\qquad (6)$$

$$H_y = \Sigma \, H_{y_i} = -\frac{1}{2\pi} \, \Sigma \, \frac{I_i \, \cos\alpha_i}{r_i} \qquad\qquad (7)$$

Da es sich bei den elektrischen Strömen eines Drehstromsystems um komplexe Größen handelt, müssen somit die Ströme der Formeln 6 und 7 durch komplexe Ströme ersetzt werden:

$$H_x = \frac{1}{2\pi} \, \Sigma \, \frac{I_i \, e^{j\varphi i}}{r_i} \, \sin\alpha_i \qquad\qquad (8)$$

$$H_y = -\frac{1}{2\pi} \, \Sigma \, \frac{I_i e^{j\varphi i}}{r_i} \, \cos\alpha_i \qquad\qquad (9)$$

Die Übertragung der Formel 8 in die goniometrische Schreibweise führt dann zu einer weiteren Unterteilung der magnetischen Feldstärke in Realteile und Imaginärteile der x-und y-Komponenten. Dadurch ergibt sich für die x-Komponente durch die Überführung von Formel 8 in die neue Schreibweise:

$$H_x = \frac{1}{2\pi} \, \Sigma \, \frac{I_i}{r_i} \, * \, (\sin\alpha_i \cos\varphi_i + j \, \sin\alpha_i \sin\varphi_i) \qquad (10)$$

Beim Überführen der y-Komponente in die goniometrische Schreibweise ist eine notwendige Drehung der Gaußschen Zahlenebene um 90° gegenüber den Betrachtungen bei der Überführung der x-Komponente und eine anschließende Spiegelung an der y-Achse zu beachten. Unter Berücksichtigung dieser Gegebenheiten ergibt sich somit folgender Zusammenhang:

$$H_y = \frac{1}{2\pi} \Sigma \frac{I_i}{r_i} * (\cos\alpha_i \sin\varphi_i - j \cos\alpha_i \cos\varphi_i) \qquad (11)$$

Mit Hilfe der Formeln 10 und 11 können nun die Beträge und Winkel der neu entstandenen komplexen Größen unter Beachtung der Rechenregeln für komplexe Größen weiter berechnet werden. Die Addition der komplexen Größen aus 10 und 11 liefert dann folgenden Ausdruck:

$$\vec{H} = \frac{1}{2\pi} \Sigma \frac{I_i}{r_i} * [(\sin\alpha_i \cos\varphi_i + \cos\alpha_i \sin\varphi_i)$$
$$+ j (\sin\alpha_i \sin\varphi_i - \cos\alpha_i \cos\varphi_i)] \qquad (12)$$

aus dem sich der Betrag der magnetischen Feldstärke zu

$$|\vec{H}| = \sqrt{Re[\vec{H}]^2 + Im[\vec{H}]^2} \qquad (13)$$

(mit Re = Realanteil und Im = Imaginäranteil)
und der Phasenwinkel zu

$$\varphi_H = \arctan \frac{Im[\vec{H}]}{Re[\vec{H}]} \qquad (14)$$

ergibt.

Ein vereinfachter Rechenansatz, der auf der Exponentialform der komplexen Größen beruht und zu gleichen Ergebnissen führt, ist in den Formeln 15 und 16 dargestellt.

$$\vec{H} = \frac{1}{2\pi} \Sigma \frac{I_i}{R_i} * e^{j\varphi} * e^{j(\alpha_i - 90°)} \qquad (15)$$

$$\vec{H} = \frac{I}{2\pi} \Sigma \frac{I_i}{r_i} * [\cos(\varphi_i + \alpha_i - 90°) + \sin(\varphi_i + \alpha_i - 90°)] \qquad (16)$$

Nachstehend wird die Möglichkeit der Messung dreier Ströme eines Drehstromdreileitersystems mit nur zwei elektronischen Stromsensoren untersucht, wobei der geometrische Meßaufbau gemäß Figur 8 zugrundeliegt. Da bei der Messung an einem Drehstromsystem mit nur zwei elektronischen Stromsensoren nur die Gewinnung von drei unabhängigen Größen

$$U_{outA} = f(\vec{H}_A) \;,\; U_{outB} = f(\vec{H}_B) \;,\; \sphericalangle U_{outA}, U_{outB} = f(\sphericalangle \vec{H}_A, \vec{H}_B)$$

möglich ist, muß eine Symmetrie der drei Ströme bezüglich ihrer Phasenwinkel vorausgesetzt werden.

Aufgrund der speziellen Eigenschaften eines magnetoresistiven Brückenelementes sind für die Betrachtungen zur magnetischen Feldstärke im Zusammenhang mit dem elektronischen Stromsensor nur die Komponenten einer geometrischen Achse entscheidend. Ursache dessen ist, daß nur eine im rechten Winkel zur Längsachse wirkende Magnetfeldkomponente den Vektor der spontanen Magnetisierung innerhalb der empfindlichen Schicht des magnetoresistiven Brückenelementes auslenkt und so zur Widerstandsänderung führt. Somit vereinfacht sich die Formel für die Berechnung, der für die Messung mit einem elektronischen Stromsensor wirksamen Feldstärke, bei günstiger Wahl des Koordinatensystems auf die Formel 10.

Eine günstige Wahl des Koordinatensystems heißt in diesem Fall, daß das Koordinatensystem so gelegt wird, daß die für den jeweiligen elektronischen Stromsensor wirksame Feldstärkekomponente identisch ist mit der X-Komponente im Koordinatensystem.

Das wiederum bedeutet, daß die Berechnung der wirksamen magnetischen Feldstärke für jeden der beiden Sensoren A und B in einem eigenen, in Figur 11 dargestellten, Koordinatensystem ($X_A$, $Y_A$ und $X_B$, $Y_B$) erfolgen muß und anschließend eine Zurückdrehung des Koordinatensystems des Sensors A um den Winkel $\beta$ notwendig wird. Mit dieser Betrachtungsweise und ausgehend von Formel 10 ergeben sich folgende Formeln und Rechenschritte zur Berechnung der wirksamen magnetischen Feldstärken an den Koordinatenpunkten der Sensoren A und B:

$$H_A = \frac{1}{2\pi} * \left( \frac{I_1}{a_1} * \sin 90° \cos 0° + \frac{I_2}{a_2} * \sin\alpha_2 \cos 240° + \frac{I_3}{a_2} * \sin\alpha_3 \cos 120° \right)$$

$$+ \; j \frac{1}{2\pi} * \left( \frac{I_1}{a_1} * \sin 90° \sin 0° + \frac{I_2}{a_2} * \sin\alpha_2 \sin 240° + \frac{I_3}{a_2} * \sin\alpha_3 \sin 120° \right) \qquad (17)$$

$$H_B = \frac{1}{2\pi} * \left( \frac{I_1}{a_2} * \sin\alpha_3 \cos 0° + \frac{I_2}{a_1} * \sin 90° \cos 240° + \frac{I_3}{a_2} * \sin\alpha_2 \cos 120° \right)$$

$$+ \; j \frac{1}{2\pi} * \left( \frac{I_1}{a_2} * \sin\alpha_3 \sin 0° + \frac{I_2}{a_1} * \sin 90° \sin 240° + \frac{I_3}{a_2} * \sin\alpha_2 \sin 120° \right) \qquad (18)$$

In bezug auf die angegebenen Abstände symbolisiert $a_1$ den kurzen und $a_2$ den größeren Abstand zwischen Sensor und Einzelleiter und in bezug auf die angegebenen geometrischen Winkel symbolisiert $\alpha_2$ jeweils den spitzen und $\alpha_3$ jeweils den stumpfen Winkel nach der in Figur 9 getroffenen Winkelvereinbarung. Die Ströme des Drehstromsystems wurden unter Beachtung der bereits getroffenen Einschränkung für die elektrischen Winkel mit:

$$\underline{I}_1 = I_1 * e^{j0°} \,,\; \underline{I}_2 = I_2 * e^{j240°} \,,\; \underline{I}_3 = I_3 * e^{j120°}$$

in die Rechnung einbezogen.

Aus den errechneten Werten der Formeln 17 bzw. 18 lassen sich dann unter Einbeziehung der Formeln 13 und 14 die Beträge und Winkel der wirksamen magnetischen Feldstärken in den Koordinatenpunkten der Sensoren A und B bestimmen. In bezug auf die dabei ermittelten Winkel ist jedoch noch die Drehung der beiden Koordinatensysteme zueinander zu beachten. Zur Bestimmung des Winkels der magnetischen Feldstärke im Punkt des Sensors A bezogen auf das Koordinatensystem $X_B$, $Y_B$ (festgelegtes Grundkoordinatensystem) ergibt sich dann folgende Berechnungsformel:

$$\varphi_{HA} = \left[ \arctan \frac{Im[\vec{H}]}{Re[\vec{H}]} \right] - 120° \tag{19}$$

Da die ermittelten Winkel der Summen der Feldstärken in den Punkten A und B meßtechnisch wegen des fehlenden zeitlichen Nullpunktes, in keinen Bezug zu den den Magnetfluß verursachenden Stromstärken stehen, ist deren Weiterverrechnung notwendig. Als dritte bisher noch nicht berechnete, mit zwei elektronischen Stromwandlern jedoch meßbare Größe dient der Winkel zwischen den beiden Ausgangsspannungssignalen bzw. zwischen den beiden Feldstärkevektoren. Dieser noch zu ermittelnde Winkel berechnet sich zu:

$$\angle \vec{H}_A, \vec{H}_B = \varphi = \varphi_{\vec{HB}} - \varphi_{\vec{HA}}$$

$$= \arctan \frac{Im[\vec{H}_B]}{Re[\vec{H}_B]} - \arctan \frac{Im[\vec{H}_A]}{Re[\vec{H}_A]} + 120° \tag{20}$$

oder über die Formel zur Berechnung des Schnittwinkels zweier Geraden, unter Beachtung der notwendigen Zurückdrehung des Koordinatensystems des Sensors A, zu:

$$\angle \vec{H}_A, \vec{H}_B = \arccos \frac{\vec{H}_A * \vec{H}_B}{H_A * H_B} + 120°$$

$$= \arccos \frac{Re[\vec{H}_A] * Re[\vec{H}_B] + Im[\vec{H}_A] * Im[\vec{H}_B]}{\sqrt{Re[\vec{H}_A]^2 + Im[\vec{H}_A]^2} * \sqrt{Re[\vec{H}_B]^2 + Im[\vec{H}_B]^2}} + 120° \tag{21}$$

Da die elektronischen Stromwandler den Funktionsverlauf der magnetischen Feldstärke eindeutig wiedergeben, ist der Winkel zwischen den Ausgangsspannungen identisch mit dem zwischen den Feldstärken auftretenden Winkel. Bei der Umrechnung der Beträge der Feldstärken in die Beträge der Ausgangsspannungen ist hingegen die Einbeziehung eines Sensorabhängigen Proportionalitätsfaktors zu berücksichtigen.

Zur Berechnung der drei Leiterströme wird schließlich mit Hilfe einer Datenverarbeitungseinrichtung eine Umstellung und Aufstellung der entsprechenden Gleichungen nach den gesuchten Größen vorgenommen.

In Anwendungsfällen, in denen es nicht auf eine Ermittlung der Leiterströme ankommt, sondern lediglich eine Betriebszustandserfassung erfolgen soll, also nur festzustellen ist, ob ein Strom fließt, kann auch mit einem einzigen Sensor gearbeitet werden. Er liefert ein Signal sobald in wenigstens einem der Leiter des Mehrleitersystems ein Strom fließt. Abgesehen von dieser Vereinfachung kann zur Betriebszustandserfassung eine Meßanordnung verwendet werden, die oben unter Bezugnahme auf Figur 1 beschrieben ist.

Im Fall eines Zweileitersystems genügt ebenfalls ein einziger Sensor zur Ermittlung der Leiterströme, da die Ströme in beiden Leitern den gleichen Betrag haben und lediglich um 180° phasenverschoben sind.

**Patentansprüche**

1. Verfahren zur Ermittlung der einzelnen Leiterströme eines Mehrleitersystems (1), wobei
   a) das Mehrleitersystem (1) eine Anzahl n>1 elektrischer Leiter (L1 bis L3) und Mittel (2,3) zur elektrischen Isolierung enthält, und

b) mit meßtechnischen Mitteln (S1 bis S3, 4 bis 7) magnetische Feldstärken vektoriell erfaßt werden, die die Summenfeldstärken der Magnetfelder aller Einzelleiter (L1 bis L3) sind,

dadurch gekennzeichnet, daß

c) die Anzahl m der Meßorte wenigstens n-1 beträgt,

d) an den Meßorten jeweils ein Sensor (S1 bis S3) unmittelbar am Mehrleitersystem (1) angeordnet wird, wobei die Sensoren (S1 bis S3) durch unterschiedliche geometrische Winkel ausreichend räumlich voneinander getrennt angeordnet werden, um deutlich unterschiedliche Wirkungen der strombegleitenden Magnetfelder der einzelnen Leiter (L1 bis L3) auf die Sensoren (S1 bis S3) zu erzielen, und

e) die Einzelströme der Leiter (L1 bis L3) auf den Grundlagen der gemessenen Feldstärken durch numerische Berechnung ermittelt werden, wobei Berechnungsformeln benutzt werden, die neben den Winkeln der Phasenverschiebung auch die geometrischen Winkel der vektoriell empfindlichen Achsen der Sensoren zueinander und die physikalischen Abhängigkeiten der vektoriellen magnetischen Feldstärken vom Meßort und von den einzelnen Leiterströmen berücksichtigen.

2. Verfahren nach Anspruch 1, dadurch gekennzeichnet, daß die Sensoren (S1 bis S3) am Mehrleitersystem (1) so angeordnet werden, daß die vektoriell empfindlichen Achsen der Sensoren in den jeweiligen Meßorten zueinander unterschiedliche geometrische Winkel aufweisen.

3. Verfahren nach Anspruch 1 oder 2, dadurch gekennzeichnet, daß die Meßorte so gewählt werden, daß sich bei gleich hohen Strömen in allen Leitern (L1 bis L3) auch gleich hohe Meßwerte für die vektorielle magnetische Feldstärke an allen Meßorten ergeben.

4. Verfahren nach einem der vorstehenden Ansprüche, dadurch gekennzeichnet, daß die vektoriellen magnetischen Feldstärken mit Sensoren erfaßt werden, die ein der vektoriellen magnetischen Feldstärke proportionales elektrisches Signal liefern.

5. Verfahren nach Anspruch 4, dadurch gekennzeichnet, daß als Sensoren magnetoresistive Halbleitersensoren verwendet werden.

6. Einrichtung zur Ermittlung der einzelnen Leiterströme eines Mehrleitersystems (1) mit Hilfe von Sensoren (S1 bis S3), die an mehreren Orten um das Mehrleitersystem (1) herum angeordnet sind, und wobei das Mehrleitersystem eine Anzahl n>1 elektrischer Leiter (L1 bis L3) und Mittel (2,3) zur elektrischen Isolierung aufweist, dadurch gekennzeichnet, daß

a) die Anzahl m der Meßorte wenigstens n-1 beträgt,

b) die Sensoren (S1 bis S3) unmittelbar am Mehrleitersystem (1) innerhalb dessen Summen-Magnetfelds angeordnet sind, und jeweils ein einer vektoriellen magnetischen Feldstärke proportionales elektrisches Meßsignal liefern,

c) das Mehrleitersystem (1) einschließlich Sensoren (S1 bis S3) von einer magnetischen Abschirmeinrichtung (4) umgeben ist, die Fremdeinflüsse auf die Meßanordnung weitgehend ausschließt, und die elektrischen Meßsignale mit Hilfe von Verbindungsleitungen (6) von den Sensoren (S1 bis S3) zu einer Meßwertverarbeitungseinrichtung (5) geführt sind, in der auf der Grundlage der Meßwerte Leiterströme berechnet und an einem Ausgang (7) zur Verfügung gestellt sind.

7. Einrichtung nach Anspruch 6, dadurch gekennzeichnet, daß als Sensoren magnetoresistive Halbleitersensoren eingesetzt sind.

8. Einrichtung nach einem der Ansprüche 6 oder 7, dadurch gekennzeichnet, daß die empfindlichen Richtungen der Sensoren so ausgerichtet sind, daß alle Leiterströme ein Maximum zum Ausgangssignal der Sensoren beitragen.

9. Verfahren zur Erfassung des Betriebszustandes eines Mehrleitersystems, das nachstehende Verfahrensmerkmale aufweist:

a) an wenigstens einem Meßort im Summen-Magnetfeld des Mehrleitersystems wird vektoriell die magnetische Summenfeldstärke meßtechnisch erfaßt, also eine vektorielle Summe der Feldstärken der Magnetfelder der Einzelleiter und

b) die vektoriell gemessene Feldstärke wird in ein elektrisches Signal umgewandelt, das zur Feststellung des Betriebszustandes ausgewertet wird.

**10.** Einrichtung zur Durchführung des Verfahrens nach Anspruch 9, das nachstehende Merkmale aufweist:

a) nahe an einem Mehrleitersystem (1) und innerhalb dessen Summen-Magnetfelds ist wenigstens ein Sensor (S1, S2, S3) angeordnet, der ein einer vektoriellen magnetischen Feldstärke proportionales elektrisches Signal liefert:

b) das Mehrleitersystem (1) einschließlich des wenigstens einen Sensors (S1, S2, S3) ist von einer magnetischen Abschirmeinrichtung (4) umgeben, die Fremdeinflüsse auf die Meßanordnung weitgehend ausschließt;

c) das wenigstens eine elektrische Meßsignal ist zu einer Auswerteeinrichtung (5) geführt, die das Meßsignal auswertet und meldet, ob ein Stromfluß vorhanden ist.

# Fig. 1

S2

S1

L2

L1

L3

1

2

3

4

S3

6

5

7

## Fig. 2

H2 ges.

S2

S1

d2
L2

d1
L1

H13

d3
L3

H12

H11

H3 ges.

S3

H1 ges.

## Fig. 3

S1y

S1

L2

L1

S1x

L3

H1x ges.

H1 ges.

H1y ges.

EP 0 597 404 A2

# Fig. 4

S1
1
L1
2
3
4
L2
L3
S2

# Fig. 5

S1
H1x ges.
L1
L2
L3
H2x ges.
S2

y

x

14

# Fig. 6

# Fig. 7

Fig. 8

Fig. 9

Fig. 10

Fig. 11